(19) **Europäisches Patentamt**
**European Patent Office**
**Office européen des brevets**

(11) **EP 3 038 253 B1**

(12) **FASCICULE DE BREVET EUROPEEN**

(45) Date de publication et mention
de la délivrance du brevet:
**06.12.2017 Bulletin 2017/49**

(51) Int Cl.:
***H03B 25/00*** *(2006.01)*  ***H03B 5/32*** *(2006.01)*

(21) Numéro de dépôt: **15201725.7**

(22) Date de dépôt: **21.12.2015**

(54) **OSCILLATEUR MULTI-MODE PERMETTANT UN SUIVI SIMULTANE DES VARIATIONS DE PLUSIEURS FREQUENCES DE RESONANCE D'UN RESONATEUR**

MULTIMODUS-OSZILLATOR, DER EINE SIMULTANNACHVERFOLGUNG DER VARIATIONEN VON MEHREREN RESONANZFREQUENZEN EINES RESONATORS ERMÖGLICHT

MULTI-MODE OSCILLATOR ALLOWING SIMULTANEOUS TRACKING OF VARIATIONS OF A PLURALITY OF RESONANCE FREQUENCIES OF A RESONATOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **22.12.2014 FR 1463107**

(43) Date de publication de la demande:
**29.06.2016 Bulletin 2016/26**

(73) Titulaire: **Commissariat à l'Énergie Atomique et aux Énergies Alternatives 75015 Paris (FR)**

(72) Inventeurs:
• **GOURLAT, Guillaume**
  **38000 Grenoble (FR)**
• **BILLIOT, Gérard**
  **38330 Saint Nazaire Les Eymes (FR)**
• **VILLARD, Patrick**
  **38000 Grenoble (FR)**

(74) Mandataire: **Brevalex**
  **95, rue d'Amsterdam**
  **75378 Paris Cedex 8 (FR)**

(56) Documents cités:
**EP-A1- 2 620 751  WO-A1-2014/064273**

• **BARGATIN I ET AL: "Efficient electrothermal actuation of multiple modes of high-frequency nanoelectromechanical resonators", APPLIED PHYSICS LETTERS, AMERICAN INSTITUTE OF PHYSICS, 2 HUNTINGTON QUADRANGLE, MELVILLE, NY 11747, vol. 90, no. 9, 28 février 2007 (2007-02-28), pages 93116-093116, XP012096284, ISSN: 0003-6951, DOI: 10.1063/1.2709620**
• **TOMAS ROUBICEK ET AL: "Digital oscillator circuit using synchronous pulse driving", ELECTRONICS, CIRCUITS AND SYSTEMS, 2008. ICECS 2008. 15TH IEEE INTERNATIONAL CONFERENCE ON, IEEE, PISCATAWAY, NJ, USA, 31 août 2008 (2008-08-31), pages 482-485, XP031362529, ISBN: 978-1-4244-2181-7**

**Description**

**DOMAINE TECHNIQUE ET ART ANTÉRIEUR**

L'invention concerne un oscillateur multi-mode dans lequel un résonateur est apte à résonner selon au moins deux modes de résonance, l'un symétrique et l'autre antisymétrique, et permettant un suivi des variations des fréquences de résonance du résonateur. L'invention concerne également un dispositif de détection comportant de tels oscillateurs multi-mode, par exemple pour une analyse de gaz ou une spectrométrie de masse.

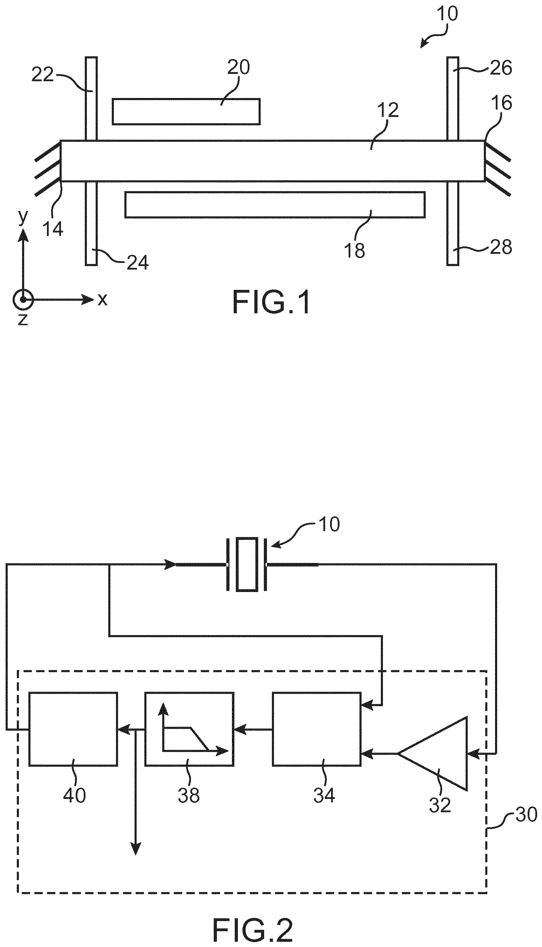

La figure 1 représente schématiquement un résonateur 10, ici un nano-résonateur, qui comporte une poutre 12 (de dimensions nanométriques dans le cas d'un nano-résonateur) formant l'élément mobile du résonateur 10 et dont les extrémités 14, 16 sont encastrées (poutre bi-encastrée). Le résonateur 10 comporte des électrodes d'actionnement 18, 20 disposées parallèlement à la poutre 12 et permettant la mise en résonance de la poutre 12 dans le plan dans lequel se trouvent la poutre 12 et les électrodes 18, 20 (plan (X,Y) sur la figure 1). L'actionnement de la poutre 12 se fait par une force électrostatique induite par les électrodes 18, 20 sur la poutre 12.

La détection du déplacement de la poutre 12 est réalisée par des jauges de contrainte piézorésistives 22, 24, 26, 28, comportant chacune une extrémité couplée mécaniquement à la poutre 12, et disposées perpendiculairement à la poutre 12 c'est-à-dire telles que chacune des jauges 22, 24, 26, 28 comporte sa plus grande dimension qui s'étend selon une direction (parallèle à l'axe Y) perpendiculaire à la plus grande dimension de la poutre 12 (la poutre 12 s'étendant selon une direction parallèle à l'axe X). Deux premières jauges 22, 24 sont disposées du côté de la première extrémité 14, de chaque côté de la poutre 12, et forment un premier pont de jauges de contrainte piézorésistives couplé à la poutre 12. Deux deuxièmes jauges 26, 28 sont disposées du côté de la deuxième extrémité 16, également de chaque côté de la poutre 12, et forment un deuxième pont de jauges de contrainte piézorésistives couplé à la poutre 12. Les jauges 22, 24, 26, 28 s'étendent dans le même plan (X,Y) que celui dans lequel vibre la poutre 12. Les distances entre la première extrémité 14 et le point de contact de la poutre 12 avec le premier pont de jauges, et entre la deuxième extrémité 16 et le point de contact de la poutre 12 avec le deuxième pont de jauges, sont choisies telles que les contraintes induites par le mouvement de la poutre 12 sur les jauges 22, 24, 26, 28 soient maximisées et telles que les jauges 22, 24, 26, 28 perturbent le moins possible le mouvement de la poutre 12.

Pour réaliser le suivi de l'évolution de la fréquence de résonance du résonateur 10, lorsque celui-ci est mis en résonance dans un seul mode de résonance, ou mode de flexion, le résonateur 10 peut être disposé au sein d'une architecture en boucle fermée permettant de suivre cette évolution de la fréquence de résonance du résonateur 10 tout en maximisant sa plage dynamique et sa résolution fréquentielle.

Une première architecture en boucle fermée représentée sur la figure 2 consiste à insérer le résonateur 10 dans une boucle à verrouillage de phase (PLL) qui asservit la phase du résonateur 10 à la valeur correspondant à sa résonance. Dans une telle PLL, un signal de sortie du résonateur 10, qui correspond par exemple à la tension électrique mesurée à l'une des extrémités 14,16 de la poutre 12, est envoyé à l'entrée d'un ensemble d'éléments électroniques 30 assurant le maintien de la résonance du résonateur 10. Ces éléments 30 comportent un amplificateur 32 recevant en entrée le signal de sortie du résonateur 10, un comparateur de phases 34 recevant sur ses entrées le signal appliqué en entrée du résonateur 10 et le signal de sortie de l'amplificateur 32, un filtre passe-bas 38 recevant en entrée le signal délivré par le comparateur de phases 34, et un oscillateur commandé en tension 40 (VCO) recevant en entrée le signal de sortie du filtre 38 et dont le signal de sortie est appliqué à l'entrée du résonateur 10. La fréquence de résonance du résonateur 10 est alors suivie au niveau du signal de sortie du filtre 38.

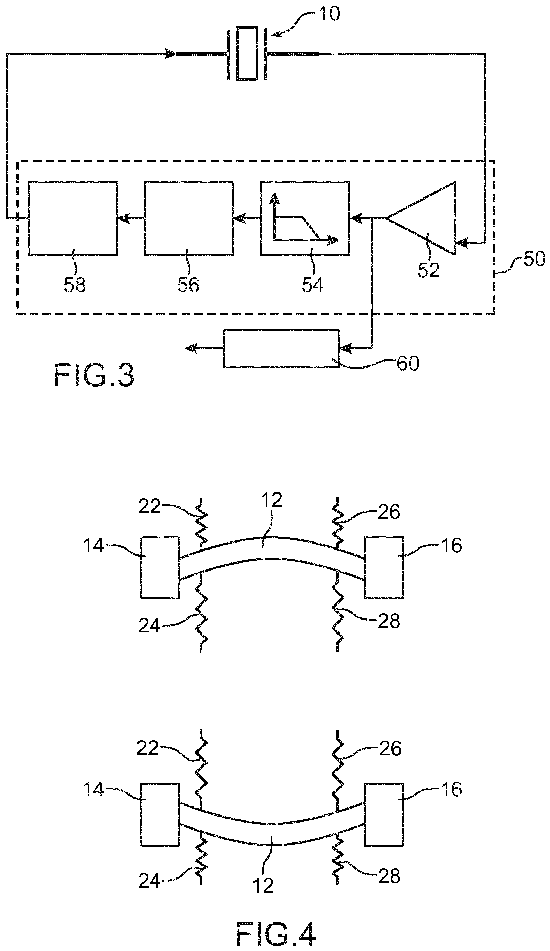

Une deuxième architecture en boucle fermée consiste à insérer le résonateur 10 dans une boucle auto-oscillante dans laquelle le résonateur 10 est placé au sein d'une chaîne d'amplification 50 assurant les conditions de gain et de déphasage nécessaires à la mise en résonance du résonateur 10 (critères de Barkhausen), comme représenté sur la figure 3. Cette chaîne 50 comporte un amplificateur 52 recevant en entrée le signal de sortie du résonateur 10, un filtre passe-bas 54 recevant en entrée le signal de sortie de l'amplificateur 52, un déphaseur 56 réalisant un déphasage du signal délivré par le filtre 54, et un limiteur d'amplitude 58 limitant l'amplitude du signal délivré par le déphaseur 56 et dont le signal de sortie est appliqué en entrée du résonateur 10. La fréquence de résonance du résonateur 10 est suivie au niveau du signal de sortie de l'amplificateur 52 par un dispositif de mesure de fréquence 60. Dans une telle boucle auto-oscillante, l'entretien de l'oscillation du résonateur 10 étant assuré, la détection se résume donc à mesurer la fréquence d'oscillation au moyen de procédés classiques tels que le comptage de périodes, à partir d'une horloge de référence de fréquence supérieure à celle de l'oscillation.

Le principal avantage de l'architecture en boucle auto-oscillante par rapport à une PLL est sa compacité due à l'absence de comparateur de phases et d'oscillateur commandé en tension.

Le résonateur 10 peut résonner simultanément selon plusieurs modes de résonnance dont les pulsations propres (ou fréquences propres) dépendent des conditions aux limites (encastrements) et des dimensions de la poutre 12. Sur l'exemple de la figure 1, la première électrode 18 est apte à exciter la poutre 12 dans son premier mode de résonance, correspondant à la fréquence fondamentale de vibration de la poutre 12, tandis que la deuxième électrode 20, dont la dimension le long de l'axe de la poutre 12 est inférieure à celle de la première électrode 18, est apte à exciter la poutre 12 dans ses premier et second modes de résonance.

Pour certaines applications, comme par exemple la spectrométrie de masse, on cherche à suivre les variations des fréquences de résonance de la poutre 12 lorsque celle-ci est en résonance dans plusieurs modes de résonance simultanément. Les deux architectures en boucle fermée précédemment décrites ne permettent toutefois pas de réaliser un tel suivi simultané du décalage des multiples fréquences de résonance du résonateur 10.

Le document « Single-protein nanomechanical mass spectrometry in real time » de M.S. Hanay et al., Nature Nanotechnology 7, 602-608 (2012), décrit une architecture hétérodyne basée sur une double PLL accrochée sur deux porteuses distinctes. Une telle architecture permet de réaliser une lecture simultanée des deux modes de résonance d'un résonateur. Toutefois, celle-ci est très encombrante et incompatible avec la réalisation d'une matrice de résonateurs par exemple pour des applications de spectrométrie de masse.

Les documents WO 2014/064273 A1, BARGATIN et al. « Efficient electrothermal actuation of multiple modes of high-frequency nanoelectromechanical resonators », Applied Physics Letters, vol. 90, n°9, 28 février 2007, EP 2 620 751 A1 et ROUBICEK et al., « Digital oscillator circuit using synchronous pulse driving », Electronics Circuits and Systems, 31 août 2008, décrivent des oscillateurs comprenant des résonateurs pouvant être mis en résonance selon plusieurs modes. Ces oscillateurs ne permettent toutefois pas de réaliser un suivi simultané des fréquences de résonance des résonateurs en résonance dans plusieurs modes simultanément.

## EXPOSÉ DE L'INVENTION

Un but de la présente invention est de proposer un oscillateur multi-mode permettant de réaliser un suivi simultané des fréquences de résonance d'un résonateur en résonance dans plusieurs modes simultanément et qui soit peu encombrant et compatible avec une réalisation en matrice de plusieurs résonateurs.

Pour cela, l'invention propose un oscillateur multi-mode comportant au moins :

- un résonateur comprenant:

    • un élément mobile ou au moins un élément mobile ;
    • des moyens d'actionnement aptes à mettre l'élément mobile en résonance selon au moins deux modes de résonance dont l'un est symétrique et l'autre est antisymétrique ;
    • plusieurs éléments de détection du déplacement de l'élément mobile comportant chacun au moins un paramètre électrique dont la valeur varie en fonction du déplacement de l'élément mobile et couplés à l'élément mobile tels qu'ils induisent, dans au moins des premier et deuxième signaux de sortie du résonateur représentatifs des variations dudit paramètre électrique, des différences de phases, ou des différences de phases à l'origine, telles que $\phi_{E1} - \phi_{O1} \neq \phi_{E2} - \phi_{O2}$, avec $\phi_{E1}$ la phase d'une première composante fréquentielle du premier signal de sortie liée à un premier des modes de résonance, $\phi_{O1}$ la phase d'une première composante fréquentielle du deuxième signal de sortie liée au premier des modes de résonance, $\phi_{E2}$ la phase d'une deuxième composante fréquentielle du premier signal de sortie liée à un deuxième des modes de résonance, et $\phi_{O2}$ la phase d'une deuxième composante fréquentielle du deuxième signal de sortie liée au deuxième des modes de résonance ;

- des moyens de polarisation aptes à appliquer sur les éléments de détection des signaux électriques de polarisation, continus ou alternatifs ;
- un premier dispositif de calcul apte à réaliser au moins une première opération entre les premier et deuxième signaux de sortie conservant les premières composantes fréquentielles des premier et deuxième signaux de sortie et annulant les deuxièmes composantes fréquentielles des premier et deuxième signaux de sortie ;
- un deuxième dispositif de calcul apte à réaliser au moins une deuxième opération entre les premier et deuxième signaux de sortie conservant les deuxièmes composantes fréquentielles des premier et deuxième signaux de sortie et annulant les premières composantes fréquentielles des premier et deuxième signaux de sortie ;

et dans lequel le résonateur et les premier et deuxième dispositifs de calcul font partie d'au moins deux boucles auto-oscillantes aptes à mettre simultanément en résonance l'oscillateur, et plus précisément le résonateur, dans les deux modes de résonance.

Le premier dispositif de calcul fait partie d'une première des deux boucles auto-oscillantes apte à mettre en résonance le résonateur dans un premier des deux modes de résonance, et le deuxième dispositif de calcul fait partie d'une deuxième des deux boucles auto-oscillantes apte à mettre en résonance le résonateur dans un deuxième des deux modes de résonance.

Pour réaliser le suivi simultané des fréquences de résonance d'au moins deux modes de résonance symétrique et antisymétrique du résonateur, qui correspondent avantageusement au premier mode de résonance (résonance selon la fréquence fondamentale) et au deuxième mode de résonance (résonance selon la fréquence harmonique 2) du résonateur, il est proposé un oscillateur multi-mode, avantageusement bi-mode, combinant un schéma de polarisation particulier du résonateur avec des dispositifs de calcul permettant de sélectionner les composantes fréquentielles des signaux de sortie correspondant à l'un ou l'autre des deux modes de résonance du résonateur.

La possibilité de pouvoir conserver, en sortie de chacun des dispositifs de calcul, les composantes fréquentielles des signaux de sortie correspondant à l'un des modes de résonance et d'annuler celles correspondant à l'autre mode de résonance est obtenue à la fois grâce au couplage particulier des éléments de détection avec l'élément mobile du résonateur qui induit un certain déphasage dans les signaux de sortie, et grâce aux signaux de polarisation particuliers appliqués sur les éléments de détection. De plus, cela est obtenu sans avoir besoin de recourir à un filtrage sélectif pour isoler la contribution de chacun des modes de résonance en sortie du dispositif.

Du fait que l'oscillateur est formé de boucles auto-oscillantes, il présente également des avantages de compacité liés à l'absence de comparateur de phases et d'oscillateur commandé en tension, ce qui le rend parfaitement adapté pour une utilisation au sein d'une architecture matricielle de tels oscillateurs multi-mode.

Les moyens de polarisation peuvent être aptes à appliquer sur les éléments de détection des signaux électriques de polarisation continus et de valeurs différentes, par exemple de signes différents et d'amplitudes identiques ou non. En variante, les moyens de polarisation peuvent être aptes à appliquer sur les éléments de détection des signaux électriques de polarisation alternatifs, ces signaux de polarisation alternatifs étant alors déphasés l'un par rapport à l'autre.

Les signaux électriques de polarisation sont tels qu'ils permettent d'obtenir dans les premier et deuxième signaux de sortie du résonateur représentatifs des variations dudit paramètre électrique, des différences de phases, ou des différences de phases à l'origine, telles que $\phi_{E1} - \phi_{O1} \neq \phi_{E2} - \phi_{O2}$,

L'élément mobile peut comporter une poutre dont les deux extrémités sont encastrées.

Avantageusement, les moyens de polarisation peuvent être tels que les signaux électriques de polarisation sont continus et de valeurs opposées, ou alternatifs et déphasés l'un par rapport à l'autre d'une valeur égale à environ 180°. Dans ce cas, la première opération est avantageusement une addition et la deuxième opération est avantageusement une soustraction. Cette configuration est particulièrement avantageuse car elle permet de discriminer simplement les deux modes de résonance.

Les moyens d'actionnement peuvent comporter une électrode apte à appliquer sur l'élément mobile une force électrostatique mettant en résonance l'élément mobile selon les deux modes de résonance, ou peuvent comporter au moins deux électrodes chacune apte à appliquer sur l'élément mobile une force électrostatique favorisant la mise en résonance de l'élément mobile selon l'un des deux modes de résonance.

Chaque élément de détection peut comporter une jauge de contrainte piézorésistive.

Dans ce cas, deux premiers des éléments de détection peuvent former un premier pont de jauges de contrainte piézorésistives, deux deuxièmes des éléments de détection peuvent former un deuxième pont de jauges de contrainte piézorésistives, et les moyens de polarisation peuvent être aptes à appliquer les signaux électriques de polarisation aux bornes de chacun des premier et deuxième ponts de jauges de contrainte piézorésistives.

Chacune des deux boucles auto-oscillantes peut comporter au moins un amplificateur et un premier déphaseur. Ces éléments peuvent servir à assurer la vérification du critère de Barkhausen au sein de chacune des boucles auto-oscillantes.

Les moyens de polarisation peuvent comporter au moins :

- deux générateurs de troisième et quatrième signaux alternatifs de fréquences différentes ;
- deux deuxièmes déphaseurs comportant chacun une entrée reliée à une sortie d'un des deux générateurs et aptes à appliquer un même déphasage aux troisième et quatrième signaux alternatifs ;
- un premier additionneur apte à recevoir en entrée le quatrième signal alternatif non déphasé et le troisième signal alternatif déphasé par l'un des deuxièmes déphaseurs, et un deuxième additionneur apte à recevoir en entrée le troisième signal alternatif non déphasé et le quatrième signal alternatif déphasé par l'autre des deuxièmes déphaseurs, les signaux destinés à être délivrés par les premier et deuxième additionneurs correspondant aux signaux électriques de polarisation qui sont alternatifs et déphasés l'un par rapport à l'autre.

Les premiers déphaseurs peuvent comporter chacun une entrée reliée à une sortie d'un des deux générateurs et aptes à appliquer un déphasage différent à chacun des troisième et quatrième signaux alternatifs, et l'oscillateur multi-mode peut comporter, dans chacune des deux boucles auto-oscillantes, un mélangeur dont une première entrée est reliée à une sortie d'un des premier et deuxième dispositifs de calcul et dont une deuxième entrée est reliée à une sortie d'un des premiers déphaseurs.

L'oscillateur multi-mode peut comporter en outre des dispositifs de mesure de fréquence aptes à mesurer les fréquences des premier et deuxième signaux de sortie.

L'invention concerne également un dispositif de détection comportant une pluralité d'oscillateurs multi-mode tels que décrits précédemment, dans lequel les résonateurs des oscillateurs multi-mode forment une matrice de détection.

L'utilisation d'oscillateurs multi-mode selon l'invention pour la conception d'un système à base de capteurs nanométriques permet d'aboutir à un système robuste ayant une efficacité de capture importante. Les oscillateurs multi-mode selon l'invention sont bien adaptés à la conception de larges matrices de capteurs en vue d'une forte intégration.

Les moyens de polarisation peuvent être communs à tous les oscillateurs multi-mode et peuvent être disposés à côté de la matrice de détection, et/ou au moins une partie des éléments des boucles auto-oscillantes des oscillateurs multi-mode autres que les résonateurs peuvent être disposés sous la matrice de détection.

Des groupes de résonateurs peuvent former des macro-pixels de la matrice de détection et au moins une partie des éléments des boucles auto-oscillantes des oscillateurs multi-mode de chaque macro-pixel autres que les résonateurs et/ou les moyens de polarisation peuvent être communs à tous les oscillateurs multi-mode dudit macro-pixel.

Le dispositif de détection est avantageusement un spectromètre de masse. En effet, l'entretien d'une double oscillation sur chacun des résonateurs peut être avantageusement utilisé pour déterminer la masse et la position d'une particule déposée sur chacun des résonateurs, comme cela est décrit plus loin dans la description détaillée. Dans ce cas, le dispositif de détection peut comporter des oscillateurs multi-mode incluant les dispositifs de mesure de fréquence aptes à mesurer les fréquences des premier et deuxième signaux de sortie, et peut comporter en outre des moyens de calcul d'une masse de particules et d'une position de dépôt de la masse de particules sur chaque résonateur des oscillateurs multi-mode à partir des mesures des fréquences des premier et deuxième signaux de sortie de chaque résonateur.

L'utilisation de résonateurs au sein d'oscillateurs multi-mode selon l'invention pour réaliser des mesures de masses très faibles, par exemple comprises entre environ $10^{-24}$ et $10^{-21}$ grammes, notamment dans les domaines de l'analyse de gaz ou la spectrométrie de masse, est particulièrement avantageuse.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- la figure 1 représente un résonateur à poutre bi-encastrée ;
- la figure 2 représente une boucle à verrouillage de phase dans laquelle est disposé un résonateur ;
- la figure 3 représente une boucle auto-oscillante dans laquelle est disposé un résonateur ;
- la figure 4 représente schématiquement les positions extrêmes de l'élément mobile du résonateur de la figure 1 lors d'une résonance selon le premier mode de résonance ;
- la figure 5 représente schématiquement les positions extrêmes de l'élément mobile du résonateur de la figure 1 lors d'une résonance selon le deuxième mode de résonance ;
- la figure 6 représente un schéma de modélisation électrique du résonateur de la figure 1 ;
- la figure 7 représente un oscillateur multi-mode, objet de la présente invention, selon un premier mode de réalisation ;
- la figure 8 représente un oscillateur multi-mode, objet de la présente invention, selon un deuxième mode de réalisation ;
- la figure 9 représente un macro-pixel d'un dispositif de détection, objet de la présente invention, selon un exemple de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

On décrit tout d'abord les propriétés d'un résonateur, par exemple celles du résonateur 10 précédemment décrit en liaison avec la figure 1, qui vont permettre de réaliser un suivi simultané des fréquences de résonance de deux modes de résonance différents du résonateur 10.

Chacune des jauges 22, 24, 26, 28 du résonateur 10 peut être assimilée à une résistance dont la valeur dépend de la contrainte induite par le mouvement de la poutre 12 sur celle-ci. Lorsque la poutre 12 vibre, les jauges 22, 24, 26, 28 sont soumises à une alternance de contraintes compressives et extensives qui diffèrent selon le ou les modes de résonnance dans lesquels se trouve la poutre 12. Etant donné la disposition des jauges 22, 24, 26, 28, celles se trouvant du côté d'une même extrémité de la poutre 12 (jauges 22, 24 qui se trouvent du côté de la première extrémité 14, et jauges 26, 28 qui se trouvent du côté de la deuxième extrémité 16) sont soumises à des contraintes opposées (l'une en compression et l'autre en extension).

Il est possible que le résonateur 10 comporte plusieurs poutres 12 par exemple reliées parallèlement les unes par rapport aux autres, c'est-à-dire dont les entrées sont reliées entre elles et dont les sorties sont reliées entre elles. Les poutres forment alors un ensemble d'éléments mobiles pouvant être assimilés à un seul élément mobile.

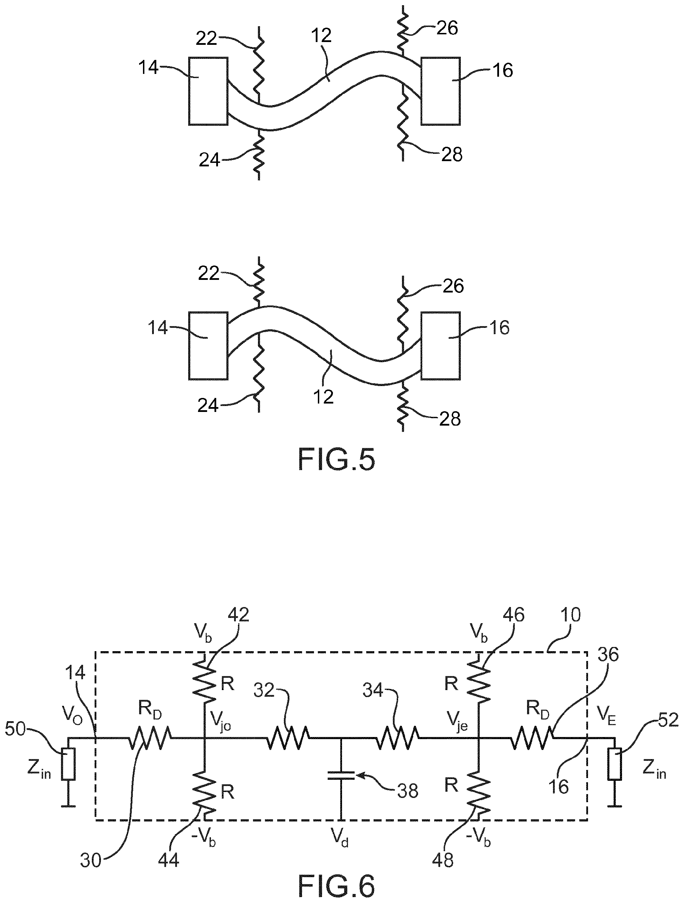

La figure 4 représente schématiquement la poutre 12 dans deux positions extrêmes lors d'une vibration selon son premier mode de résonance (fréquence fondamentale), tandis que la figure 5 représente schématiquement la poutre 12 dans deux positions extrêmes lors d'une vibration selon son deuxième mode de résonance (fréquence harmonique 2).

Les contraintes appliquées aux jauges 22, 24, 26, 28 dans les différents modes de résonance de fréquences propres $f_n$ ($f_1$ pour le premier mode et $f_2$ pour le deuxième mode) se traduisent par des variations relatives de résistance différentes dans les jauges qui sont notées $\delta R_{fn}(t)$ est homogène à $\Delta R(t)/R$. En considérant que les quatre jauges 22, 24, 26, 28 sont similaires (même valeur de résistance R en l'absence de contrainte subie par la jauge et, pour un même mouvement de la poutre 12, même variation relative $\delta R_{fn}(t)$ de la valeur de la résistance de la jauge), les valeurs des résistances des jauges qui se trouvent aux deux extrémités de la poutre 12 et du même côté de la poutre 12 (les jauges 22, 26 d'une part, et les jauges 24, 28 d'autre part) varient de manière similaire pour une résonance selon le premier mode qui est un mode de résonance symétrique, et de manière opposée pour une vibration selon le deuxième mode qui est un mode de résonance antisymétrique.

Dans la première position représentée en haut de la figure 4 et dans laquelle les jauges 22 et 26 sont en compression et les jauges 24 et 28 sont en extension, les jauges 22 et 26 ont chacune une résistance égale à R - R.$\delta R_{f1}(t)$, et les jauges 24 et 28 ont une résistance égale à R + R.$\delta R_{f1}(t)$. Dans la deuxième position représentée en bas de la figure 4 et dans laquelle les jauges 22 et 26 sont en extension et les jauges 24 et 28 sont en compression, les jauges 22 et 26 ont une résistance égale à R + R.$\delta R_{f1}(t)$, et les jauges 24 et 28 ont une résistance égale à R - R.$\delta R_{f1}(t)$.

Dans la première position représentée en haut de la figure 5 et dans laquelle les jauges 22 et 28 sont en extension et les jauges 24 et 26 sont en compression, les jauges 22 et 28 ont une résistance égale à R + R.$\delta R_{f2}(t)$, et les jauges 24 et 26 ont une résistance égale à R - R.$\delta R_{f2}(t)$. Dans la deuxième position représentée en bas de la figure 5 et dans laquelle les jauges 22 et 28 sont en compression et les jauges 24 et 26 sont en extension, les jauges 22 et 28 ont une résistance égale à R - R.$\delta R_{f2}(t)$, et les jauges 24 et 26 ont une résistance égale à R + R.$\delta R_{f2}(t)$.

Le résonateur 10 peut être modélisé électriquement par le schéma de la figure 6. Les résistances 30, 32, 34 et 36 modélisent différentes parties de la poutre 12. La capacité 38 modélise les électrodes 18, 20. Chacune des résistances 42, 44, 46, 48 modélise respectivement l'une des jauges 22, 24, 26, 28. Les impédances 50 et 52 représentent les impédances d'entrée des éléments de mise en oeuvre du résonateur vues au niveau des extrémités 14 et 16 de la poutre 12.

L'image des fréquences de résonance mécanique de la poutre 12 est obtenue par la variation relative de résistance $\delta R_{fn}(t)$ des jauges piézorésistives. La polarisation des jauges par des tensions de polarisation continues de signes opposés sur chacun des ponts de jauges 22, 24 et 26, 28 (par exemple +$V_b$ appliqué sur les jauges 22, 26 et -$V_b$ appliqué sur les jauges 24, 28) permet de générer au sein du résonateur 10 un signal électrique exploitable par l'électronique associée au résonateur 10 pour réaliser le suivi des variations des fréquences de résonance. Les tensions Vo et $V_E$ correspondent aux tensions mesurées respectivement aux extrémités 14 et 16 de la poutre 12, et les tensions $V_{jO}$ et $V_{jE}$ correspondent aux tensions au niveau des points milieu des ponts de jauges, l'un des ponts étant formé par les jauges 22 et 24 et l'autre étant formé par les jauges 26 et 28.

Les jauges 22, 24, 26, 28 sont couplées à la poutre 12 telles qu'elles induisent, dans les signaux de sortie du résonateur 10 correspondant aux tensions Vo et $V_E$, des différences de phases telles que $\phi_{E1} - \phi_{O1} \neq \phi_{E2} - \phi_{O2}$, avec $\phi_{E1}$ la phase de la composante fréquentielle de la tension $V_E$ liée au premier mode de résonance, $\phi_{O1}$ la phase de la composante fréquentielle de la tension Vo liée au premier mode de résonance, $\phi_{E2}$ la phase de la composante fréquentielle de la tension $V_E$ liée au deuxième mode de résonance, et $\phi_{O2}$ la phase de la composante fréquentielle de la tension Vo liée au deuxième mode de résonance. Pour obtenir ces différences de phases, les tensions de polarisation continues appliquées sur chacun des ponts de jauges 22, 24 et 26, 28 sont de valeurs différentes, et avantageusement de signes différents. Dans le cas de tensions de polarisation alternatives, celles-ci sont déphasées l'une par rapport à l'autre.

Dans la configuration où la polarisation appliquée de part et d'autre de chacun des ponts de jauges correspond à des tensions continues de signes opposés ou des tensions alternatives déphasées de 180° de part et d'autre du pont de jauges, les tensions $V_{jO}$ et $V_{jE}$ peuvent être exprimées selon les équations suivantes :

$$V_{jE} = \frac{\left(1 + \delta R_{fn}(t)\right)V_b - \left(1 - \delta R_{fn}(t)\right)V_b}{2 + \dfrac{R}{Z_{in} + R_D}} \qquad (1)$$

$$V_{jO} = \frac{\left(1 + \delta R_{fn}(t)\right)V_b - \left(1 - \delta R_{fn}(t)\right)V_b}{2 + \dfrac{R}{Z_{in} + R_D}} \qquad (2)$$

avec $R_D$ correspondant à la valeur de chacune des résistances 30 et 36, et $Z_{in}$ correspondant à la valeur de chacune des impédances d'entrée 50 et 52 de l'électronique associée.

Lorsque les tensions $V_{jO}$ et $V_{jE}$ correspondent à des tensions alternatives, celles-ci sont alors fonction du temps. La tension de polarisation s'exprime dans ce cas par l'équation suivante :

$$V_b(t) = \cos(2\pi f_{bn} t + \phi_{bn})$$

Avec $f_{bn}$ et $\phi_{bn}$ correspondant respectivement à la fréquence et à la phase du signal de polarisation.
En outre, la variation relative de résistance $\delta R_{fn}(t)$ s'exprime selon l'équation suivante :

$$\delta R_{fn}(t) = \frac{\Delta R}{R}\cos(2\pi f_n t + \phi_n)$$

De plus, $\delta R_{fn}(t) \ll 1$.
En considérant que le courant circulant dans la poutre 12 est nul, les tensions $V_O$ et $V_E$ peuvent être exprimées selon les équations suivantes :

$$V_E = \frac{\delta R_{fn}(t).V_b}{1 + \dfrac{R}{2.Z_{in}} + \dfrac{R_D}{Z_{in}}} \qquad (3)$$

$$V_O = \frac{\delta R_{fn}(t).V_b}{1 + \dfrac{R}{2.Z_{in}} + \dfrac{R_D}{Z_{in}}} \qquad (4)$$

Les tensions $V_E$ et $V_O$ exprimées ci-dessus sont fonction du temps lorsque des tensions de polarisation alternatives sont utilisées.
De plus, en supposant que les valeurs des impédances d'entrée $Z_{in}$ de l'électronique associée tendent vers l'infini :

$$V_O = V_b . \delta R_{fn}(t) \qquad (5)$$

$$V_E = V_b . \delta R_{fn}(t) \qquad (6)$$

Ainsi, du fait que le premier mode de résonance est symétrique et que le second mode de résonance est antisymétrique, les tensions $V_O$ et $V_E$ dans les deux modes de résonance peuvent être exprimées selon les équations suivantes :

| Mode de résonance | $V_E$ | $V_O$ |
|---|---|---|
| Mode 1 | $V_b . \delta R_{f1}(t)$ | $V_b . \delta R_{f1}(t)$ |
| Mode 2 | $V_b . \delta R_{f2}(t)$ | $-V_b . \delta R_{f2}(t)$ |

Le fait que pour le mode 2, la tension $V_O$ soit de signe opposé à celui de la tension $V_E$ provient du fait que la variation relative de résistance induite par le second mode $\delta R_{f2}(t)$, entre le premier et le second pont de jauges est déphasée de 180°.

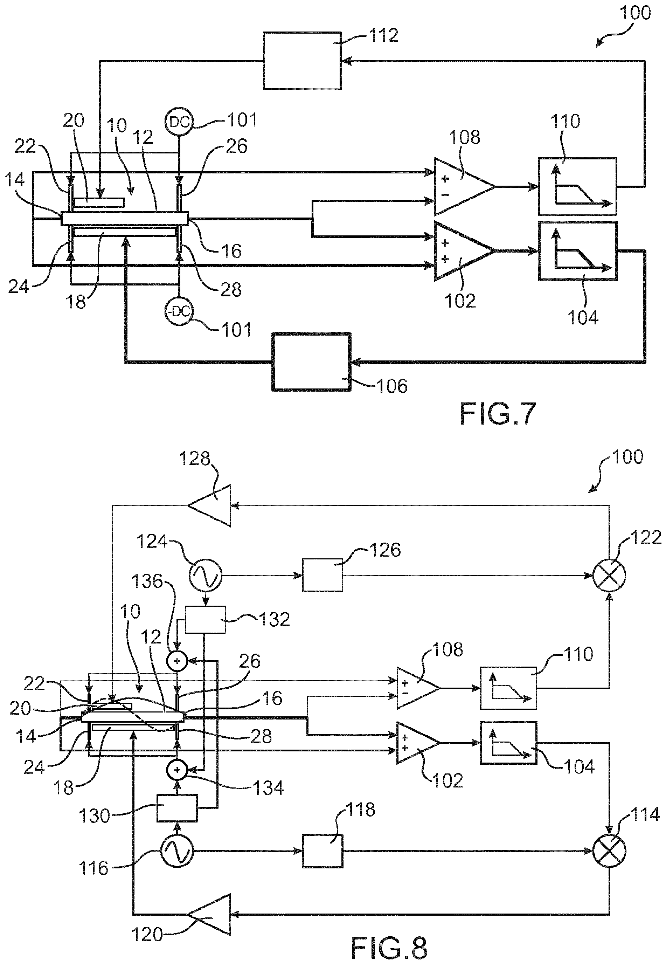

Pour réaliser le suivi simultané des fréquences de résonance de deux modes de résonance successifs du résonateur, un oscillateur multi-mode 100 selon un premier mode de réalisation est décrit en liaison avec la figure 7.

L'oscillateur 100 comporte un résonateur 10 correspondant par exemple au résonateur 10 précédemment décrit en liaison avec les figures 1 et 4 à 6. Un potentiel électrique positif de polarisation (correspondant au potentiel $V_b$ précédemment décrit sur la figure 4) est appliqué sur les jauges de contrainte 22 et 26. Un potentiel électrique négatif de polarisation (correspondant au potentiel $-V_b$ précédemment décrit sur la figure 4) est appliqué sur les jauges de contrainte 24 et 28. Les potentiels électriques sont générés par un générateur de tension 101.

Des signaux périodiques de fréquences d'excitation différentes sont appliqués sur les électrodes 18 et 20 et sont tels que la poutre 12 résonne selon deux modes de résonance différents tels que l'un soit symétrique (correspondant donc à l'un des modes impairs) et que l'autre soit antisymétrique (un des modes pairs). Avantageusement, ces deux modes de résonance correspondent aux deux premiers modes de résonance de la poutre 12.

Le dispositif 100 comporte une première boucle auto-oscillante formée d'un premier amplificateur 102, également appelé amplificateur de mode commun, formant un sommateur et délivrant en sortie un signal amplifié correspondant à la somme des potentiels électriques aux extrémités 14 et 16 de la poutre 12. Le signal de sortie du premier amplificateur 102 est appliqué sur l'entrée d'un premier filtre passe-bas 104 permettant d'éliminer les composantes haute-fréquences du signal de sortie du premier amplificateur 102, par exemple les composantes de fréquences supérieures à environ 1 MHz. Le signal de sortie du premier filtre passe-bas 104 est appliqué sur l'entrée d'un premier déphaseur 106 délivrant en sortie le signal d'excitation appliqué sur l'électrode 18 qui permet de mettre la poutre 12 en résonance dans son premier mode de résonance.

Dans cette première boucle auto-oscillante, étant donné que les potentiels $V_O$ et $V_E$ aux extrémités 14 et 16 de la poutre 12 comportent tous les deux la composante fréquentielle $V_b.\delta R_{f1}(t)$ correspondant au mode 1 et que, pour le mode 2, le potentiel $V_E$ comporte la composante fréquentielle $-V_b.\delta R_{f2}(t)$ et le potentiel $V_O$ comporte la composante fréquentielle $V_b.\delta R_{f2}(t)$, le signal délivré en sortie du premier amplificateur 102 est représentatif de la variation de la fréquence de résonance $f_1$ correspondant au mode 1 puisque l'addition réalisée permet de conserver, dans le spectre du signal de sortie du premier amplificateur 102, les composantes fréquentielles concernant le mode 1 ($V_E+V_O = 2.V_b.\delta R_{f1}(t)$ pour le mode 1), et de supprimer les composantes fréquentielles du mode 2 ($V_E+V_O = -V_b.\delta R_{f2}(t) + V_b.\delta R_{f2}(t) = 0$ pour le mode 2).

Le premier amplificateur 102 et le premier déphaseur 106 présents dans la première boucle auto-oscillante sont tels qu'ils permettent de garantir l'oscillation du résonateur 10 dans le premier mode de résonance, c'est-à-dire assurent que le déphasage total entre l'entrée du résonateur 10 et sa sortie, et le retour vers l'entrée du résonateur 10 via les éléments de la première boucle auto-oscillante, c'est-à-dire pour un tour complet de la boucle, est un nombre entier multiple de 360°, et que le gain dans la première boucle auto-oscillante est égal à 1 (critère de stabilité de Barkhausen).

Le dispositif 100 comporte également une deuxième boucle auto-oscillante formée d'un deuxième amplificateur 108, appelé amplificateur différentiel, délivrant en sortie un signal amplifié correspondant à la différence des potentiels électriques aux extrémités 14 et 16 de la poutre 12. Le signal de sortie du deuxième amplificateur 108 est appliqué sur l'entrée d'un deuxième filtre passe-bas 110, par exemple similaire au premier filtre passe-bas 104 permettant d'éliminer les composantes haute-fréquences du signal de sortie du deuxième amplificateur 108. Le signal de sortie du deuxième filtre passe-bas 110 est appliqué sur l'entrée d'un deuxième déphaseur 112 délivrant en sortie le signal d'excitation appliqué sur l'électrode 20 qui permet de mettre la poutre 12 en résonance dans son deuxième mode de résonance.

Dans cette deuxième boucle auto-oscillante, étant donné que les potentiels $V_O$ et $V_E$ aux extrémités 14 et 16 comportent tous les deux la composante fréquentielle $V_b.\delta R_{f1}(t)$ correspondant au mode 1 et que, pour le mode 2, le potentiel $V_E$ comporte la composante fréquentielle $-V_b.\delta R_{f2}(t)$ et le potentiel $V_O$ comporte la composante fréquentielle $V_b.\delta R_{f2}(t)$, le signal délivré en sortie du deuxième amplificateur 108 est représentatif de la variation de la fréquence de résonance $f_2$ correspondant au mode 2 puisque la soustraction réalisée permet de conserver, dans le spectre du signal de sortie du deuxième amplificateur 108, les composantes fréquentielles concernant le mode 2 ($V_O-V_E = -2.V_b.\delta R_{f2}(t)$ pour le mode 2), et de supprimer les composantes fréquentielles du mode 1 ($V_O-V_E = V_b.\delta R_{f1}(t) - V_b.\delta R_{f1}(t) = 0$ pour le mode 1).

Le deuxième amplificateur 108 et le deuxième déphaseur 112 présents dans la deuxième boucle auto-oscillante sont tels qu'ils permettent de garantir l'oscillation du résonateur 10 dans le deuxième mode de résonance, c'est à dire assurent que le déphasage total entre l'entrée du résonateur 10 et sa sortie, et le retour vers l'entrée du résonateur 10 via les éléments de la deuxième boucle auto-oscillante est un nombre entier multiple de 360°, et que le gain dans la deuxième boucle auto-oscillante est égal à 1.

Ainsi, l'oscillateur 100 utilise judicieusement le fait qu'un ou plusieurs des modes de résonance du résonateur 10 soient symétriques (cas du mode 1) et qu'un ou plusieurs autres modes de résonance du résonateur 10 soient antisymétriques (cas du mode 2). Ainsi, la lecture différentielle réalisée dans la deuxième boucle de l'oscillateur 100 par le deuxième amplificateur 108 permet d'éliminer les composantes fréquentielles relatives au(x) mode(s) de résonance symétrique(s) et de ne conserver que celles relatives au(x) mode(s) de résonance antisymétrique(s). Inversement, la somme réalisée dans la première boucle du dispositif 100 par le premier amplificateur 102 permet d'éliminer les composantes fréquentielles relatives au(x) mode(s) de résonance antisymétrique(s) et de ne conserver que celles relatives au(x) mode(s) de résonance symétrique(s).

En variante de la configuration précédemment décrite en liaison avec la figure 7, il est possible que les potentiels électriques de polarisation soient inversés par rapport à ceux précédemment décrits, c'est-à-dire avoir par exemple le potentiel positif appliqué sur les jauges 24 et 28 et le potentiel négatif appliqué sur les jauges 22 et 26.

Selon une autre variante, il est possible que les potentiels électriques de polarisation soient inversés par rapport à ceux précédemment décrits uniquement pour un des deux ponts de jauges, c'est-à-dire avoir par exemple le potentiel positif appliqué sur les jauges 24 et 26 et le potentiel négatif appliqué sur les jauges 22 et 28, ou bien avoir le potentiel positif appliqué sur les jauges 22 et 28 et le potentiel négatif appliqué sur les jauges 24 et 26. Dans cette variante, la lecture différentielle réalisée dans la deuxième boucle de l'oscillateur 100 par le deuxième amplificateur 108 permet d'éliminer les composantes fréquentielles relatives au(x) mode(s) de résonance antisymétrique(s) et de ne conserver que celles relatives au(x) mode(s) de résonance symétrique(s). Le signal de sortie délivré par le deuxième amplificateur 108 ne comporte donc par exemple que les composantes fréquentielles relatives au mode de résonance 1 et non celles du mode de résonance 2. La somme réalisée dans la première boucle de l'oscillateur 100 par le premier amplificateur 102 permet d'éliminer les composantes fréquentielles relatives au(x) mode(s) de résonance symétrique(s) et de ne conserver que celles relatives au(x) mode(s) de résonance antisymétrique(s). Le signal de sortie délivré par le deuxième amplificateur 108 ne comporte donc que les composantes fréquentielles relatives au mode 2 et non celles du mode 1.

L'oscillateur 100 selon ce premier mode de réalisation forme une double boucle auto-oscillante homodyne dans laquelle les fréquences de résonance du résonateur 10 imposent les fréquences d'oscillation du signal tout au long du chemin du signal dans ce système rebouclé.

En variante du premier mode de réalisation précédemment décrit, il est possible que le dispositif résonant 100 ne comporte pas l'un ou les deux filtres passe-bas 104, 110, par exemple lorsque les signaux de sortie d'un ou des deux amplificateurs 102, 108 ne comportent pas de composantes haute-fréquence perturbant la mise en oscillation du résonateur, du fait que ce ou ces amplificateurs ont un effet filtrant suffisant vis-à-vis de ces composantes haute-fréquence.

En variante de ce premier mode de réalisation, il est également possible que, dans l'une ou chacune des boucles auto-oscillantes, l'élément réalisant l'opération entre les signaux de sortie du résonateur 10 et celui réalisant l'amplification du signal correspondant au résultat de l'opération réalisée soient deux éléments distincts.

Un oscillateur multi-mode 100 selon un deuxième mode de réalisation est décrit en liaison avec la figure 8.

Comme dans le premier mode de réalisation, l'oscillateur 100 comporte le résonateur 10 couplé à deux boucles auto-oscillantes. Une première des deux boucles comporte, comme dans le premier mode de réalisation, le premier amplificateur 102 apte à réaliser la somme des potentiels $V_O$ et $V_E$ aux extrémités 14 et 16 de la poutre 12. La sortie du premier amplificateur 102 est reliée à l'entrée du premier filtre passe-bas 104. La sortie du premier filtre passe-bas 104 est reliée à une première entrée d'un premier mélangeur 114. Un premier générateur 116 génère un premier signal périodique, par exemple sinusoïdal, et comporte sa sortie reliée à l'entrée d'un premier déphaseur 118 dont la sortie est reliée à une deuxième entrée du premier mélangeur 114. La sortie du premier mélangeur 114 est reliée à l'entrée d'un troisième amplificateur 120 qui délivre en sortie le signal de commande de l'électrode 18 du résonateur 10.

La deuxième boucle auto-oscillante comporte le deuxième amplificateur 108 délivrant en sortie un signal correspondant à la différence Vo - $V_E$, et le deuxième filtre passe-bas 110, comme dans le premier mode de réalisation. Les autres éléments de la deuxième boucle auto-oscillante sont analogues à ceux de la première boucle, c'est-à-dire correspondent à un deuxième mélangeur 122 dont une entrée est reliée à la sortie du deuxième filtre passe-bas 110, un deuxième générateur 124 délivrant un deuxième signal périodique, par exemple sinusoïdal, de fréquence différente de celui délivré par le premier générateur 116 et appliqué à l'entrée d'un deuxième déphaseur 126 dont la sortie est reliée à une deuxième entrée du deuxième mélangeur 122, et un quatrième amplificateur 128 dont l'entrée est reliée à la sortie du deuxième mélangeur 122 et qui délivre en sortie le signal de commande de l'électrode 20 du résonateur 10.

Chacun des signaux délivrés par les générateurs 116, 124 est également déphasé de 180° par des déphaseurs 130 et 132. Un premier additionneur 134 réalise la somme du premier signal périodique déphasé de 180° et du deuxième signal périodique non déphasé. Le signal de sortie du premier additionneur 134 est appliqué sur les jauges de contraintes 24 et 28. Un deuxième additionneur 136 réalise la somme du premier signal périodique non déphasé et du deuxième signal périodique déphasé de 180°. Les signaux de polarisation peuvent être appliqués selon les différentes configurations précédemment décrites pour le premier mode de réalisation.

Dans ce deuxième mode de réalisation, l'accord en fréquence dans chacune des boucles est assuré par les mélangeurs 114 et 122. L'accord de phase dans les boucles est assuré par les déphaseurs 118, 126 combinés aux mélangeurs 114, 122. Les oscillateurs 116 et 124 délivrent chacun un signal de fréquence ωb1 et ωb2 respectivement.

Les signaux appliqués sur les électrodes 18 et 20 sont des signaux périodiques comportant notamment des composantes de fréquence ωr1 (pour le signal appliqué sur l'électrode 18) et ωr2 (pour le signal appliqué sur l'électrode 20). Les signaux obtenus en sortie des filtres passe-bas 104 et 108 ont respectivement pour fréquences Δω1 = ωb1 - ωr1 et Δω2 = ωb2 - wr2. Les potentiels de sortie $V_O$ et $V_E$ comportent chacun les composantes de fréquences Δω1 et Δω2.

Les signaux de polarisation utilisés ici sont multi-fréquentiels, avec deux composantes de fréquence ωb1 et ωb2, et pour chaque composante fréquentielle, le déphasage est prédéterminé, c'est-à-dire constant. Pour des signaux de polarisation alternatifs, un déphasage constant est ici obtenu à partir de signaux périodiques de fréquences différentes et multiples l'une de l'autre.

Dans ce deuxième mode de réalisation, les moyens de polarisation du résonateur 10 servent également pour abaisser la fréquence des signaux de sortie du résonateur 10. Dans cette configuration dite hétérodyne, les signaux de sortie du résonateur 10 sont à des fréquences différentes (plus basses) que celles utilisées pour la mise en résonance, c'est-à-dire celles des signaux appliqués sur les électrodes 18, 20. Afin de réaliser des boucles auto-oscillantes, les signaux en sortie des filtres passe-bas 104 et 110 sont adaptés aux fréquences adéquates pour la mise en résonance de la poutre 12.

Comme dans le premier mode de réalisation, l'oscillateur 100 selon ce deuxième mode de réalisation utilise judicieusement le fait que les modes de résonance du résonateur 10 peuvent être soit symétriques (cas du mode 1) soit antisymétriques (cas du mode 2). La lecture différentielle réalisée dans la deuxième boucle du dispositif 100 par le deuxième amplificateur 108 permet d'éliminer les composantes fréquentielles relatives aux modes de résonance symétriques et de ne conserver que celles relatives aux modes de résonance antisymétriques. Inversement, la somme réalisée dans la première boucle du dispositif 100 par le premier amplificateur 102 permet d'éliminer les composantes fréquentielles relatives aux modes de résonance antisymétriques et de ne conserver que celles relatives aux modes de résonance symétriques.

Dans l'exemple décrit ci-dessus les tensions de polarisation alternatives comportent un déphasage de 180° l'une par rapport à l'autre. La sélection des composantes fréquentielles des modes symétriques ou antisymétriques est donc obtenue en réalisant des opérations correspondant à une addition et à une soustraction. En variante, ce déphasage peut être différent de 180°. Dans ce cas, la discrimination entre les modes de résonance symétriques et antisymétriques est obtenue en réalisant des opérations autres qu'une addition et qu'une soustraction, ces opérations étant fonction de la valeur de ce déphasage.

En variante du deuxième mode de réalisation précédemment décrit, il est possible que l'oscillateur 100 ne comporte pas les filtres passe-bas 104, 110, comme précédemment décrit pour le premier mode de réalisation. De plus, il est également possible qu'un ou les deux amplificateurs 120, 128 se trouvant entre les sorties des mélangeurs 114, 122 et les électrodes 18, 20 ne soient pas présents si le gain au sein d'une ou des boucles auto-oscillantes est suffisant pour que le résonateur 10 entre en résonance dans les deux modes.

En variante, il est également possible que, dans l'une ou chacune des boucles auto-oscillantes, l'élément réalisant l'opération entre les signaux de sortie du résonateur 10 et celui réalisant l'amplification du signal correspondant au résultat de l'opération réalisée soient deux éléments distincts.

Dans l'exemple de résonateur 10 précédemment décrit, deux électrodes 18, 20 sont utilisées pour mettre la poutre 12 en résonance dans les deux modes de résonance. En variante, le résonateur de l'oscillateur 100 peut comporter une seule électrode apte à mettre la poutre 12 en résonance dans les deux modes de résonance souhaités en appliquant sur cette unique électrode les deux signaux de fréquence d'excitation différentes. Sur l'exemple du résonateur 10 représenté sur la figure 1, cette unique électrode correspondrait à la deuxième électrode 20.

De plus, dans l'exemple précédemment décrit, le résonateur 10 comporte quatre jauges de contrainte. En variante, il est possible que le résonateur 10 comporte seulement deux jauges de contraintes, chacune disposée du côté d'une extrémité différente de la poutre 12. Ces deux jauges de contraintes peuvent être disposées au niveau de deux côtés opposés ou non de la poutre 12. Par analogie avec l'exemple du résonateur 10 représenté sur la figure 1, ces deux jauges de contrainte correspondraient aux jauges 22 et 28, ou bien aux jauges 24 et 26, ou aux jauges 22 et 26, ou encore aux jauges 24 et 28.

Les propriétés de résonance du résonateur 10 selon au moins deux modes de résonance distincts et la possibilité de l'oscillateur 100 de suivre les variations des fréquences de résonance du résonateur 10 selon ces modes de résonance peuvent être avantageusement utilisées dans le cadre de la spectrométrie de masse. En effet, un décalage de la fréquence de résonnance d'un résonateur induit par la présence de particules, avantageusement des particules neutres, ou bien des particules chargées électriquement ou des molécules ionisées, à la surface du résonateur dépend à la fois de sa masse et de sa position d'adsorption sur le résonateur. La mesure du décalage de la fréquence de résonnance d'au moins deux modes de résonance, l'un symétrique et l'autre antisymétrique, et avantageusement deux modes de résonance successifs tels que les modes 1 et 2, d'un résonateur présentant des conditions aux limites symétriques permet donc de déterminer la masse et la position des particules déposées sur le résonateur.

Ainsi, en notant $f_n$ les fréquences de résonance propres du résonateur 10 dans les modes de résonance considérés (par exemple notée $f_1$ et $f_2$ pour les modes 1 et 2), Δm la masse déposée à la surface de la poutre 12, $M_{effn}$

la masse effective de la poutre 12 pour le mode n, $\Delta f$ la variation de fréquence relative et $\phi_n(x)$ la forme d'onde du mode n calculée à la position x de la masse (position de la masse sur la poutre 12 le long de l'axe parallèle à sa longueur, c'est-à-dire l'axe X sur l'exemple de la figure 1), la relation suivante est alors vérifiée pour chacune des fréquences de résonance $f_n$ du résonateur :

$$\Delta m \approx \frac{\Delta f . \Phi_n ( x_0 )}{f_n . 2 . M_{effn}} \qquad (7)$$

avec $x_0$ correspondant à la position de la masse déposée sur la poutre 12.

L'équation (7) ci-dessus posée pour deux fréquences $f_n$ différentes (deux modes de résonance) permet donc déterminer la masse et la position des particules déposées sur le résonateur doublement encastré.

Ainsi, des oscillateurs 100 tels que précédemment décrits sont avantageusement utilisés au sein d'un spectromètre de masse comportant une matrice de pixels, chaque pixel comportant un résonateur couplé dans un oscillateur 100 tel que précédemment décrit et permettant le suivi du décalage d'au moins deux fréquences de résonance du résonateur de chaque oscillateur 100. Le spectromètre de masse comporte également des moyens de calculs permettant de déduire, à partir de l'équation (7) appliquée aux deux variations de fréquence de résonance mesurées, la position x de la masse déposée et enfin la masse $\Delta m$ déposée sur chacun des résonateurs des oscillateurs 100.

Dans un tel spectromètre de masse, un grand nombre de résonateurs de dimensions nanométriques sont organisés en réseau pour former la matrice de pixels. Au sein de la matrice de pixels, plusieurs oscillateurs 100 peuvent former des macro-pixels dans lesquels certains éléments peuvent être mis en commun.

Ainsi, lorsque les oscillateurs 100 sont tels que l'oscillateur 100 selon le premier mode de réalisation précédemment décrit, les moyens de polarisation du résonateur 10 appliquant les potentiels $+V_b$ et $-V_b$ sur les jauges de contraintes 22, 24, 26 et 28 peuvent être communs à tous les oscillateurs 100 d'un même macro-pixel, voir à tous les oscillateurs 100 de la matrice de pixels du spectromètre de masse.

De plus, les amplificateurs 102, 108, les filtres passe-bas 104, 110 et les déphaseurs 106, 112 peuvent être communs à plusieurs oscillateurs 100 d'un même macro-pixel. Ces éléments sont dans ce cas reliés successivement aux résonateurs 10 des oscillateurs 100 du macro-pixel afin d'adresser successivement les oscillateurs 100 du macro-pixel.

Lorsque les oscillateurs 100 correspondent à des dispositifs tels que l'oscillateur 100 selon le deuxième mode de réalisation précédemment décrit, les moyens de polarisation du résonateur 10, c'est-à-dire les générateurs 116, 124 et les déphaseurs 118, 126, 130, 132, peuvent être communs à tous les oscillateurs 100 d'un même macro-pixel voir à tous les oscillateurs 100 de la matrice de pixels. Les amplificateurs 102, 108, les filtres 104, 110, les mélangeurs 114, 122 et les amplificateurs 120, 128 peuvent être communs à tous les oscillateurs 100 du macro-pixel.

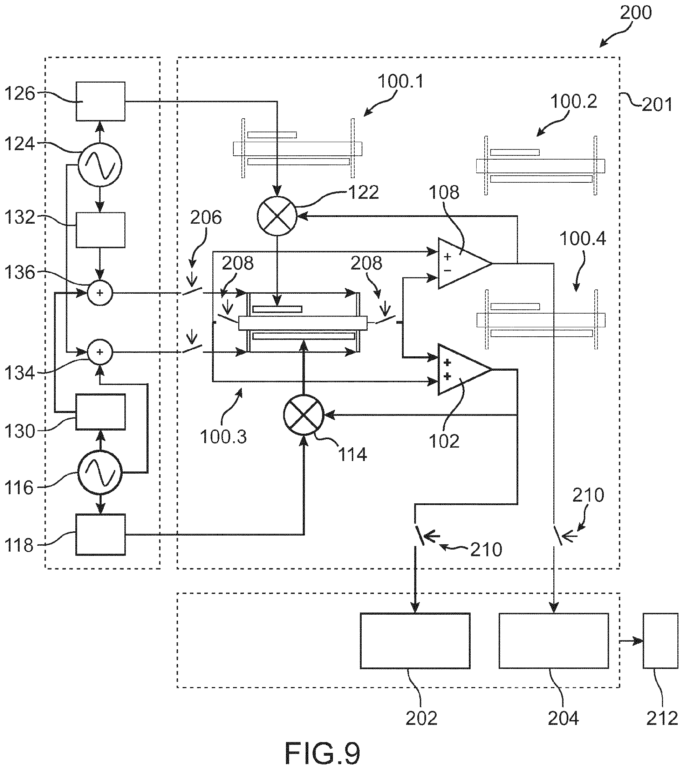

La figure 9 représente un exemple de réalisation d'un tel macro-pixel 201 d'un dispositif de détection 200 correspondant à un spectromètre de masse. Le macro-pixel 201 est formé ici de quatre pixels. Chacun des quatre pixels est formé par un oscillateur multi-mode, référencés 100.1 à 100.4 sur la figure 9. Les moyens de polarisation des quatre oscillateurs 100.1 - 100.4 sont ici communs à ces quatre oscillateurs 100.1 - 100.4 (et éventuellement communs également aux autres macro-pixels du dispositif 200) et correspondent aux moyens de polarisation de l'oscillateur 100 précédemment décrit en liaison avec la figure 8, c'est-à-dire sont formés des deux générateurs 116, 124 de signaux alternatifs de fréquences différentes, des déphaseurs 118, 126, 130 et 132 et des additionneurs 134, 136 précédemment décrits et disposés en bout de ligne du macro-pixel 201.

Dans l'exemple de la figure 9, les moyens de polarisation sont reliés en permanence à tous les résonateurs présents dans le macro-pixel 201, ce qui permet de minimiser le nombre d'interrupteurs présents dans le macro-pixel 201. En variante, il est possible d'avoir des interrupteurs reliant successivement les moyens de polarisation aux différents résonateurs du macro-pixel 201. Ainsi, les moyens de polarisation sont reliés successivement à chacun des résonateurs 100.1, 100.2, 100.3 et 100.4, permettant de sélectionner le pixel en fonctionnement au sein du macro-pixel 201. De plus, les deux sorties de chacun des résonateurs 100.1, 100.2, 100.3 et 100.4 sont commutées à l'entrée des deux boucles oscillantes du macro-pixel. Les sorties des deux boucles oscillantes sont connectées en permanence aux quatre résonateurs du macro-pixel. Dans une variante, il est possible d'avoir les moyens de polarisation reliés en permanence aux quatre résonateurs 100.1, 100.2, 100.3 et 100.4 afin de minimiser le nombre d'interrupteurs présents dans le macro-pixel 201.

Chaque pixel comporte son propre résonateur 10. Le macro-pixel 201 comporte deux amplificateurs 102, 108 et deux mélangeurs 114, 122 qui sont communs aux oscillateurs 100.1-100.4 du macro-pixel 201. Des premiers interrupteurs 206 permettent de relier les moyens de polarisation successivement au résonateur 10 de chacun des oscillateurs 100.1-100.4. Des deuxièmes interrupteurs 208 permettent de relier les extrémités de la poutre du résonateur de chacun des oscillateurs 100.1-100.4 successivement aux entrées des amplificateurs 102, 108. En variante, il serait possible que chaque oscillateur 100.1-100.4 comporte deux amplificateurs et deux mélangeurs propres à chaque oscillateur.

Contrairement à l'oscillateur 100 représenté sur la figure 8, les oscillateurs 100.1 - 100.4 ne comportent ici pas les filtres passe-bas 104, 110 ni les amplificateurs 120, 128.

Le macro-pixel 201 comporte également deux dispositifs de mesure de fréquence 202, 204 permettant de mesurer simultanément les variations de fréquence d'un des résonateurs 10 dans les deux modes de résonance. Des troisièmes interrupteurs 210 permettent de coupler les dispositifs 202, 204 successivement à chacun des oscillateurs 100.1- 100.4. Le détecteur 200 comporte en outre des moyens 212 de calcul d'une masse de particules et d'une position de dépôt de la masse de particules sur chaque résonateur 10 des oscillateurs à partir des mesures des fréquences des premier et deuxième signaux de sortie de chaque résonateur 10.

Cette conception très compacte des pixels d'un spectromètre de masse permet de former une matrice comportant un grand nombre d'oscillateurs.

Dans un tel spectromètre de masse 200, le fait que les moyens de polarisation ne soit pas communs à tous les macro-pixels de la matrice mais à une partie seulement des macro-pixels de la matrice permet de s'affranchir des dispersions au sein de la matrice de pixels.

L'architecture du macro-pixel 201 représenté sur la figure 9 permet notamment d'augmenter le facteur de remplissage des résonateurs tout en ménageant de l'espace sur le substrat semi-conducteur servant à la réalisation de l'électronique associée. Cette architecture permet d'augmenter le temps disponible pour la lecture des variations des fréquences de résonance d'un résonateur.

Bien que sur la figure 9 les résonateurs de chacun des oscillateurs 100.1 - 100.4 soient représentés dans un même plan que les éléments électroniques formant les boucles auto-oscillantes des oscillateurs, les résonateurs des oscillateurs 100.1-100.4 sont en fait hybridés au-dessus de ces éléments électroniques.

Dans la configuration représentée sur la figure 9, chaque oscillateur 100.1 - 100.4 est connecté aux moyens de mise en oscillations aux travers des interrupteurs 206, 208 pendant un intervalle de temps restreint. Pour une surface S occupée par ces éléments électroniques, le nombre de pixels inclus dans un macro-pixel peut correspondre au nombre maximal de résonateur pouvant être disposés dans cette surface S.

**Revendications**

1. Oscillateur (100) multi-mode comportant au moins :

   - un résonateur (10) comprenant :

     • un élément mobile (12) ;
     • des moyens d'actionnement (18, 20) aptes à mettre l'élément mobile (12) en résonance selon au moins deux modes de résonance dont l'un est symétrique et l'autre est antisymétrique ;
     • plusieurs éléments de détection (22, 24, 26, 28) du déplacement de l'élément mobile (12) comportant chacun au moins un paramètre électrique dont la valeur varie en fonction du déplacement de l'élément mobile (12) et couplés à l'élément mobile (12) tels qu'ils induisent, dans au moins des premier et deuxième signaux de sortie du résonateur (10) représentatifs des variations dudit paramètre électrique, des différences de phases telles que $\phi_{E1} - \phi_{O1} \neq \phi_{E2} - \phi_{O2}$, avec $\phi_{E1}$ la phase d'une première composante fréquentielle du premier signal de sortie liée à un premier des modes de résonance, $\phi_{O1}$ la phase d'une première composante fréquentielle du deuxième signal de sortie liée au premier des modes de résonance, $\phi_{E2}$ la phase d'une deuxième composante fréquentielle du premier signal de sortie liée à un deuxième des modes de résonance, et $\phi_{O2}$ la phase d'une deuxième composante fréquentielle du deuxième signal de sortie liée au deuxième des modes de résonance ;

     - des moyens de polarisation (101, 116, 124, 130, 132, 134, 136) aptes à appliquer sur les éléments de détection des signaux électriques de polarisation ;
     - un premier dispositif de calcul (102) apte à réaliser au moins une première opération entre les premier et deuxième signaux de sortie conservant les premières composantes fréquentielles des premier et deuxième signaux de sortie et annulant les deuxièmes composantes fréquentielles des premier et deuxième signaux de sortie ;
     - un deuxième dispositif de calcul (108) apte à réaliser au moins une deuxième opération entre les premier et deuxième signaux de sortie conservant les deuxièmes composantes fréquentielles des premier et deuxième signaux de sortie et annulant les premières composantes fréquentielles des premier et deuxième signaux de sortie ;

   et dans lequel le résonateur (10) et les premier et deuxième dispositifs de calcul (102, 108) font partie d'au moins deux boucles auto-oscillantes aptes à mettre simultanément en résonance le résonateur (10) dans les deux modes de résonance, le premier dispositif de calcul (102) faisant partie d'une première des deux boucles auto-oscillantes apte à mettre en résonance le résonateur (10) dans un premier des deux modes de résonance, et le deuxième dispositif de calcul (108) faisant partie d'une deuxième des deux boucles auto-oscillantes apte à mettre en résonance le résonateur (10) dans un deuxième des deux modes de résonance.

2. Oscillateur (100) multi-mode selon la revendication 1, dans lequel l'élément mobile (12) comporte une poutre dont les deux extrémités (14, 16) sont encastrées.

3. Oscillateur (100) multi-mode selon l'une des revendications précédentes, dans lequel les moyens de polarisation (101, 116, 124, 130, 132, 134, 136) sont tels que les signaux électriques de polarisation sont continus et de valeurs différentes, ou alternatifs et déphasés l'un par rapport à l'autre.

4. Oscillateur (100) multi-mode selon la revendication 3, dans lequel la première opération est une addition et la deuxième opération est une soustraction.

5. Oscillateur (100) multi-mode selon l'une des revendications précédentes, dans lequel les moyens d'actionnement comportent une électrode (20) apte à appliquer sur l'élément mobile (12) une force électrostatique mettant en résonance l'élément mobile (12) selon les deux modes de résonance, ou comportent au moins deux électrodes (18, 20) chacune apte à appliquer sur l'élément mobile (12) une force électrostatique favorisant la mise en résonance de l'élément mobile (12) selon l'un des deux modes de résonance.

6. Oscillateur (100) multi-mode selon l'une des revendications précédentes, dans lequel chaque élément de détection (22, 24, 26, 28) comporte une jauge de contrainte piézorésistive.

7. Oscillateur (100) multi-mode selon la revendication 6, dans lequel :

   - deux premiers (22, 24) des éléments de détection forment un premier pont de jauges de contrainte piézorésistives ;
   - deux deuxièmes (26, 28) des éléments de détection forment un deuxième pont de jauges de contrainte piézorésistives ; et
   - les moyens de polarisation (101, 116, 124, 130, 132, 134, 136) sont aptes à appliquer les signaux électriques de polarisation aux bornes de chacun des premier et deuxième ponts de jauges de contrainte piézorésistives.

8. Oscillateur (100) multi-mode selon l'une des revendications précédentes, dans lequel chacune des deux boucles auto-oscillantes comporte au moins un amplificateur (102, 108) et un premier déphaseur (106, 112, 118, 126).

9. Oscillateur (100) multi-mode selon la revendication 8, dans lequel les moyens de polarisation comportent au moins :

   - deux générateurs (116, 124) de troisième et quatrième signaux alternatifs de fréquences différentes ;
   - deux deuxièmes déphaseurs (130,132) comportant chacun une entrée reliée à une sortie d'un des deux générateurs (116, 124) et aptes à appliquer un même déphasage aux troisième et quatrième signaux alternatifs ;
   - un premier additionneur (134) apte à recevoir en entrée le quatrième signal alternatif non déphasé et le troisième signal alternatif déphasé par l'un des deuxièmes déphaseurs (132), et un deuxième additionneur (136) apte à recevoir en entrée le troisième signal alternatif non déphasé et le quatrième signal alternatif déphasé par l'autre des deuxièmes déphaseurs (130), les signaux destinés à être délivrés par les premier et deuxième additionneurs (134, 136) correspondant aux signaux électriques de polarisation qui sont alternatifs et déphasés l'un par rapport à l'autre.

10. Oscillateur (100) multi-mode selon la revendication 9, dans lequel les premiers déphaseurs (118, 126) comportent chacun une entrée reliée à une sortie d'un des deux générateurs (116, 124) et aptes à appliquer un déphasage différent à chacun des troisième et quatrième signaux alternatifs, et comportant en outre, dans chacune des deux boucles auto-oscillantes, un mélangeur (114, 122) dont une première entrée est reliée à une sortie d'un des premier et deuxième dispositifs de calcul (102, 108) et dont une deuxième entrée est reliée à une sortie d'un des premiers déphaseurs (118, 126).

11. Oscillateur (100) multi-mode selon l'une des revendications précédentes, comportant en outre des dispositifs de mesure de fréquence (202, 204) aptes à mesurer les fréquences des premier et deuxième signaux de sortie.

**EP 3 038 253 B1**

12. Dispositif (200) de détection comportant une pluralité d'oscillateurs (100) multi-mode selon l'une des revendications précédentes, dans lequel les résonateurs (10) des oscillateurs (100) multi-mode forment une matrice de détection.

13. Dispositif (200) de détection selon la revendication 12, dans lequel les moyens de polarisation (101, 116, 124, 130, 132, 134, 136) sont communs à tous les oscillateurs (100) multi-mode et sont disposés à côté de la matrice de détection, et/ou dans lequel au moins une partie des éléments (102, 104, 106, 108, 110, 112, 114, 120, 122, 128) des boucles auto-oscillantes des oscillateurs (100) multi-mode autres que les résonateurs (10) sont disposés sous la matrice de détection.

14. Dispositif (200) de détection selon l'une des revendications 12 ou 13, dans lequel des groupes de résonateurs forment des macro-pixels (201) de la matrice de détection, et au moins une partie des éléments (102, 104, 106, 108, 110, 112, 114, 118, 120, 122, 126, 128) des boucles auto-oscillantes des oscillateurs (100) multi-mode de chaque macro-pixel (201) autres que les résonateurs (10) et/ou les moyens de polarisation (101, 116, 124, 130, 132, 134, 136) sont communs à tous les oscillateurs (100) multi-mode dudit macro-pixel (201).

15. Dispositif (200) de détection selon l'une des revendications 12 à 14, comportant des oscillateurs multi-mode selon la revendication 11, et dans lequel ledit dispositif de détection est un spectromètre de masse et comporte en outre des moyens (212) de calcul d'une masse de particules et d'une position de dépôt de la masse de particules sur chaque résonateur (10) des oscillateurs (100) multi-mode à partir des mesures des fréquences des premier et deuxième signaux de sortie de chaque résonateur (10).

**Patentansprüche**

1. Multimoden-Oszillator (100), zumindest enthaltend:

   - einen Resonator (10) mit

     • einem beweglichen Element (12);
     • Betätigungseinrichtungen (18, 20), die dazu geeignet sind, das bewegliche Element (12) nach zumindest zwei Resonanzmoden in Schwingung zu versetzen, von denen der eine symmetrisch und der andere antisymmetrisch ist;
     • mehrere Detektionselemente (22, 24, 26, 28) zum Erfassen der Verlagerung des beweglichen Elements (12), die jeweils zumindest einen elektrischen Parameter aufweisen, dessen Wert in Abhängigkeit von der Verlagerung des beweglichen Elements (12) variiert, und die mit dem beweglichen Element (12) so gekoppelt sind, dass sie bei zumindest einem ersten und einem zweiten Ausgangssignal des Resonators (10), die für Änderungen des elektrischen Parameters repräsentativ sind, Phasendifferenzen induzieren, so dass $\phi_{E1}$ - $\phi_{O1} \neq \phi_{E2}$ - $\phi_{O2}$, wobei $\phi_{E1}$ die Phase einer ersten Frequenzkomponente des ersten Ausgangssignals ist, die mit einem ersten der Resonanzmoden verbunden ist, $\phi_{O1}$ die Phase einer ersten Frequenzkomponente des zweiten Ausgangssignals ist, die mit einem ersten der Resonanzmoden verbunden ist, $\phi_{E2}$ die Phase einer zweiten Frequenzkomponente des ersten Ausgangssignals ist, die mit einem zweiten der Resonanzmoden verbunden ist, und $\phi_{O2}$ die Phase einer zweiten Frequenzkomponente des zweiten Ausgangssignals ist, die mit einem zweiten der Resonanzmoden verbunden ist;

   - Polarisierungseinrichtungen (101, 116, 124, 130, 132, 134, 136), die dazu geeignet sind, an die Detektionselemente elektrische Polarisierungssignale anzulegen;
   - eine erste Rechenvorrichtung (102), die dazu geeignet ist, zumindest eine erste Operation zwischen dem ersten und dem zweiten Ausgangssignal durchzuführen, bei welcher die ersten Frequenzkomponenten des ersten und des zweiten Ausgangssignals beibehalten werden und die zweiten Frequenzkomponenten des ersten und des zweiten Ausgangssignals aufgehoben werden;
   - eine zweite Rechenvorrichtung (108), die dazu geeignet ist, zumindest eine zweite Operation zwischen dem ersten und dem zweiten Ausgangssignal durchzuführen, bei welcher die zweiten Frequenzkomponenten des ersten und des zweiten Ausgangssignals beibehalten werden und die ersten Frequenzkomponenten des ersten und des zweiten Ausgangssignals aufgehoben werden;

   und wobei der Resonator (10) und die erste und die zweite Rechenvorrichtung (102, 108) zu zumindest zwei selbstschwingenden Schleifen gehören, die dazu geeignet sind, den Resonator (10) gleichzeitig in beiden Resonanzmoden in Schwingung zu versetzen, wobei die erste Rechenvorrichtung (102) zu einer ersten der beiden selbstschwingenden Schleifen gehört, die dazu geeignet ist, den Resonator (10) in einem ersten der beiden Resonanzmoden in Schwingung zu versetzen, und die zweite Rechenvorrichtung (108) zu einer zweiten der beiden selbstschwingenden Schleifen gehört, die dazu geeignet ist, den Resonator (10) in einem zweiten der beiden Resonanzmoden in Schwingung zu versetzen.

2. Multimoden-Oszillator (100) nach Anspruch 1, wobei das bewegliche Element (12) einen Balken enthält, dessen beide Enden (14, 16) eingebettet sind.

3. Multimoden-Oszillator (100) nach einem der vorangehenden Ansprüche, wobei die Polarisierungseinrichtungen (101, 116, 124, 130, 132, 134, 136) derart sind, dass die elektrischen Polarisierungssignale Gleichspannungssignale unterschiedlichen Wertes oder zueinander phasenverschobene Wechselspannungssignale sind.

4. Multimoden-Oszillator (100) nach Anspruch 3, wobei die erste Operation eine Addition und die zweite Operation eine Subtraktion ist.

5. Multimoden-Oszillator (100) nach einem der vorangehenden Ansprüche, wobei die Betätigungseinrichtungen eine Elektrode (20) enthalten, die dazu geeignet ist, auf das bewegliche Element (12) eine elektrostatische Kraft aufzubringen, welche das bewegliche Element (12) nach den beiden Resonanzmoden in Schwingung versetzt, oder zumindest zwei Elektroden (18, 20) enthalten, die jeweils dazu geeignet sind, auf das bewegliche Element (12) eine elektrostatische Kraft aufzubringen, welche das in Schwingungversetzen des beweglichen Elements (12) nach einem der beiden Resonanzmoden begünstigt.

6. Multimoden-Oszillator (100) nach einem der vorangehenden Ansprüche, wobei jedes Detektionselement (22, 24, 26, 28) einen piezoresistiven Dehnungsmessstreifen enthält.

7. Multimoden-Oszillator (100) nach Anspruch 6, wobei:

- zwei erste Detektionselemente (22, 24) eine erste Brücke aus piezoresistiven Dehnungsmessstreifen bilden;
- zwei zweite Detektionselemente (26, 28) eine zweite Brücke aus piezoresistiven Dehnungsmessstreifen bilden; und
- die Polarisierungseinrichtungen (101, 116, 124, 130, 132, 134, 136) dazu geeignet sind, die elektrischen Polarisierungssignale an die Anschlussklemmen einer jeden aus erster und zweiter Brücke piezoresistiver Dehnungsmessstreifen anzulegen.

8. Multimoden-Oszillator (100) nach einem der vorangehenden Ansprüche, wobei jede der beiden selbstschwingenden Schleifen zumindest einen Verstärker (102, 108) und einen ersten Phasenschieber (106, 112, 118, 126) enthält.

9. Multimoden-Oszillator (100) nach Anspruch 8, wobei die Polarisierungseinrichtungen zumindest enthalten:

- zwei Signalgeneratoren (116, 124) für ein drittes und ein viertes Wechselspannungssignal unterschiedlicher Frequenz;
- zwei zweite Phasenschieber (130, 132), die jeweils einen Eingang haben, der mit einem Ausgang eines der beiden Signalgeneratoren (116, 124) verbunden ist, und die dazu geeignet sind, eine gleiche Phasenverschiebung an das dritte und das vierte Wechselspannungssignal anzulegen;
- einen ersten Addierer (134), der dazu geeignet ist, am Eingang das nicht phasenverschobene vierte Wechselspannungssignal und das durch einen der zweiten Phasenschieber (132) phasenverschobene, dritte Signal zu empfangen, sowie einen zweiten Addierer (136), der dazu geeignet ist, am Eingang das nicht phasenverschobene dritte Wechselspannungssignal und das durch den anderen der zweiten Phasenschieber (130) phasenverschobene, vierte Signal zu empfangen, wobei die Signale dazu bestimmt sind, von dem ersten und dem zweiten Addierer (134, 136) ausgegeben zu werden, die den elektrischen Polarisierungssignalen entsprechen, die Wechselspannungssignale und zueinander phasenverschoben sind.

10. Multimoden-Oszillator (100) nach Anspruch 9, wobei die ersten Phasenschieber (118, 126) jeweils einen Eingang enthalten, der mit einem Ausgang eines der beiden Signalgeneratoren (116, 124) verbunden ist, und dazu geeignet sind, eine unterschiedliche Phasenverschiebung an jedem aus dritten und vierten Wechselspannungssignal anzuwenden, und ferner bei jeder der selbstschwingenden Schleifen einen Mischer (114, 122) enthalten, von dem ein erster Eingang mit einem Ausgang einer aus erster und zweiter Rechenvorrichtung (102, 108) verbunden ist und von dem ein zweiter Eingang mit einem Ausgang eines der ersten Phasenschieber (118, 126) verbunden ist.

**11.** Multimoden-Oszillator (100) nach einem der vorangehenden Ansprüche, ferner enthaltend Frequenzmessvorrichtungen (202, 204), die dazu geeignet sind, die Frequenzen des ersten und des zweiten Ausgangssignals zu messen.

**12.** Detektionsvorrichtung (200), enthaltend eine Mehrzahl von Multimoden-Oszillatoren (100) nach einem der vorangehenden Ansprüche, wobei die Resonatoren (10) der Multimoden-Oszillatoren (100) eine Detektionsmatrix bilden.

**13.** Detektionsvorrichtung (200) nach Anspruch 12, wobei die Polarisierungseinrichtungen (101, 116, 124, 130, 132, 134, 136) allen Multimoden-Oszillatoren (100) gemein sind und neben der Detektionsmatrix angeordnet sind, und/oder wobei zumindest ein Teil der neben den Resonatoren (10) weiteren Elemente (102, 104, 106, 108, 110, 112, 114, 120, 122, 128) der selbstschwingenden Schleifen der Multimoden-Oszillatoren (100) unter der Detektionsmatrix angeordnet sind.

**14.** Detektionsvorrichtung (200) nach einem der Ansprüche 12 oder 13, wobei Gruppen von Resonatoren Makropixel (201) der Detektionsmatrix bilden und zumindest ein Teil der neben den Resonatoren (10) weiteren Elemente (102, 104, 106, 108, 110, 112, 114, 118, 120, 122, 126, 128) der selbstschwingenden Schleifen der Multimoden-Oszillatoren (100) eines jeden Mikropixels (201) und/oder die Polarisierungseinrichtungen (101, 116, 124, 130, 132, 134, 136) allen Multimoden-Oszillatoren (100) des Mikropixels (201) gemein sind.

**15.** Detektionsvorrichtung (200) nach einem der Ansprüche 12 bis 14, enthaltend Multimoden-Oszillatoren nach Anspruch 11, wobei die Detektionsvorrichtung ein Massespektrometer ist und ferner Recheneinrichtungen (212) zum Berechnen einer Teilchenmasse und einer Ablagerungsposition der Teilchenmasse auf jeden Resonator (10) der Multimoden-Oszillatoren (100) ausgehend von Messungen der Frequenzen des ersten und des zweiten Ausgangssignals eines jeden Resonators (10) enthält.

**Claims**

**1.** Multimode oscillator (100) comprising at least:

- a resonator (10) including:

  • at least one moving element (12);
  • actuation means (18, 20) able to make the moving element (12) resonate according to at least two resonance modes of which one is symmetric and the other is antisymmetric;
  • several detectors (22, 24, 26, 28) of the displacement of the moving element (12) each comprising at least one electrical parameter of which the value varies as a function of the displacement of the moving element (12) and coupled to the moving element (12) such that they induce, in at least first and second output signals of the resonator (10) representative of the variations in said electrical parameter, phase differences such that $\phi_{E1} - \phi_{O1} \neq \phi_{E2} - \phi_{O2}$, with $\phi_{E1}$ the phase of a first frequential component of the first output signal linked to a first of the resonance modes, $\phi_{O1}$ the phase of a first frequential component of the second output signal linked to the first of the resonance modes, $\phi_{E2}$ the phase of a second frequential component of the first output signal linked to a second of the resonance modes, and $\phi_{O2}$ the phase of a second frequential component of the second output signal linked to the second of the resonance modes;

- polarization means (101, 116, 124, 130, 132, 134, 136) able to apply to the detectors electric polarization signals;
- a first calculator (102) able to carry out at least one first operation between the first and second output signals conserving the first frequential components of the first and second output signals and cancelling the second frequential components of the first and second output signals;
- a second calculator (108) able to carry out at least one second operation between the first and second output signals conserving the second frequential components of the first and second output signals and cancelling the first frequential components of the first and second output signals;

and in which the resonator (10) and the first and second calculators (102, 108) form part of at least two self-oscillating loops able to make the resonator (10) resonate simultaneously in the two resonance modes, wherein the first calculator (102) belongs to a first of the two self-oscillating loops able to make the resonator (10) resonate in a first of the two resonance modes, and the second calculator (108) belongs to a second of the two self-oscillating loops able to make the resonator (10) resonate in a second of the two resonance modes.

2. Multimode oscillator (100) according to claim 1, in which the moving element (12) comprises a beam of which the two ends (14, 16) are built-in.

3. Multimode oscillator (100) according to one of previous claims, in which the polarization means (101, 116, 124, 130, 132, 134, 136) are such that the electric polarization signals are continuous and of different values, or alternating and out of phase with respect to each other.

4. Multimode oscillator (100) according to claim 3, in which the first operation is an addition and the second operation is a subtraction.

5. Multimode oscillator (100) according to one of previous claims, in which the actuation means comprise an electrode (20) able to apply to the moving element (12) an electrostatic force making the moving element (12) resonate according to the two resonance modes, or comprise at least two electrodes (18, 20) each able to apply to the moving element (12) an electrostatic force favouring making the moving element (12) resonate according to one of the two resonance modes.

6. Multimode oscillator (100) according to one of previous claims, in which each detector (22, 24, 26, 28) comprises a piezoresistive strain gauge.

7. Multimode oscillator (100) according to claim 6, in which:

   - two first detectors (22, 24) form a first piezoresistive strain gauge bridge;
   - two second detectors (26, 28) form a second piezoresistive strain gauge bridge; and
   - the polarization means (101, 116, 124, 130, 132, 134, 136) are able to apply the electric polarization signals to the terminals of each of the first and second piezoresistive strain gauge bridges.

8. Multimode oscillator (100) according to one of previous claims, in which each of the two self-oscillating loops comprises at least one amplifier (102, 108) and one first phase shifter (106, 112, 118, 126).

9. Multimode oscillator (100) according to claim 8, in which the polarization means comprise at least:

   - two generators (116, 124) of third and fourth alternating signals of different frequencies;
   - two second phase shifters (130,132) each comprising an input connected to an output of one of the two generators (116, 124) and able to apply a same phase shift to the third and fourth alternating signals;
   - a first adder (134) able to receive at input the fourth alternating signal not phase shifted and the third alternating signal phase shifted by one of the second phase shifters (132), and a second adder (136) able to receive at input the third alternating signal not phase shifted and the fourth alternating signal phase shifted by the other of the second phase shifters (130), the signals intended to be outputted by the first and second adders (134, 136) corresponding to the electric polarization signals which are alternating and phase shifted with respect to each other.

10. Multimode oscillator (100) according to claim 9, in which the first phase shifters (118, 126) each comprise an input connected to an output of one of the two generators (116, 124) and able to apply a different phase shift to each of the third and fourth alternating signals, and further comprising, in each of the two self-oscillating loops, a mixer (114, 122) of which a first input is connected to an output of one of the first and second calculators (102, 108) and of which a second input is connected to an output of one of the first phase shifters (118, 126).

11. Multimode oscillator (100) according to one of previous claims, further comprising frequency measurement devices (202, 204) able to measure the frequencies of the first and second output signals.

12. Detection device (200) comprising a plurality of multimode oscillators (100) according to one of previous claims, in which the resonators (10) of the multimode oscillators (100) form a detection array.

13. Detection device (200) according to claim 12, in which the polarization means (101, 116, 124, 130, 132, 134, 136) are common to all of the multimode oscillators (100) and are arranged beside the detection array, and/or in which at least a part of the elements (102, 104, 106, 108, 110, 112, 114, 120, 122, 128) of the self-oscillating loops of the multimode oscillators (100) other than the resonators (10) are arranged under the detection array.

**14.** Detection device (200) according to one of claims 12 or 13, in which groups of resonators form macro-pixels (201) of the detection array, and at least a part of the elements (102, 104, 106, 108, 110, 112, 114, 118, 120, 122, 126, 128) of the self-oscillating loops of the multimode oscillators (100) of each macro-pixel (201) other than the resonators (10) and/or the polarization means (101, 116, 124, 130, 132, 134, 136) are common to all of the multimode oscillators (100) of said macro-pixel (101).

**15.** Detection device (200) according to one of claims 12 to 14, comprising multimode oscillators according to claim 11, and in which said detector is a mass spectrometer and further comprises a calculation means (212) of a mass of particles and a position of deposition of the mass of particles on each resonator (10) of the multimode oscillators (100) from frequency measurements of the first and second output signals of each resonator (10).

FIG.1

FIG.2

FIG.3

FIG.4

FIG.5

FIG.6

FIG.7

FIG.8

FIG.9

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2014064273 A1, BARGATIN

- EP 2620751 A1

**Littérature non-brevet citée dans la description**

- **M.S. HANAY et al.** Single-protein nanomechanical mass spectrometry in real time. *Nature Nanotechnology,* 2012, vol. 7, 602-608
- Efficient electrothermal actuation of multiple modes of high-frequency nanoelectromechanical resonators. *Applied Physics Letters,* 28 Février 2007, vol. 90 (9

- **ROUBICEK et al.** Digital oscillator circuit using synchronous pulse driving. *Electronics Circuits and Systems,* 31 Août 2008